(19) Europäisches Patentamt
European Patent Office
Office européen des brevets

(11) **EP 3 550 591 A1**

(12) # EUROPEAN PATENT APPLICATION
published in accordance with Art. 153(4) EPC

(43) Date of publication:
**09.10.2019 Bulletin 2019/41**

(21) Application number: **17877266.1**

(22) Date of filing: **28.11.2017**

(51) Int Cl.:
*H01L 21/205* [(2006.01)]   *C23C 16/30* [(2006.01)]
*C23C 16/34* [(2006.01)]   *H01L 21/338* [(2006.01)]
*H01L 29/778* [(2006.01)]   *H01L 29/812* [(2006.01)]

(86) International application number:
**PCT/JP2017/042694**

(87) International publication number:
**WO 2018/101280 (07.06.2018 Gazette 2018/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **30.11.2016 JP 2016231901**

(71) Applicant: **Sumitomo Chemical Company, Limited
Tokyo 104-8260 (JP)**

(72) Inventors:
- **YAMAMOTO Taiki
  Tsukuba-shi
  Ibaraki 300-3294 (JP)**
- **OSADA Takenori
  Hitachi-shi
  Ibaraki 319-1418 (JP)**

(74) Representative: **Vossius & Partner
Patentanwälte Rechtsanwälte mbB
Siebertstrasse 3
81675 München (DE)**

(54) **SEMICONDUCTOR SUBSTRATE**

(57)   A semiconductor wafer is provided, which has a buffer layer having a stacked structure in which first crystal layers formed of $Al_xGa_{1-x}N$ and second crystal layers formed of $Al_yGa_{1-y}N$ are repeatedly stacked, where when TEM observation of a cross-section of the buffer layer is performed at an observation region including one of the first crystal layers, HAADF-STEM intensity I(D) being a function of a depth D takes a local minimum value Imin at a depth Dmin and takes a local maximum value Imax at a depth Dmax (Dmax > Dmin), and a depth direction distance DD1 from a depth at which the I(D) takes an intermediate value Imid of the Imax and the Imin to a depth at which the I(D) takes the Imin in a monotonous decrease region disposed shallower than the Dmin, and a depth direction distance DD2 from a depth at which the I(D) takes the Imin to a depth at which the I(D) takes the Imax in a monotonous increase region disposed deeper than the Dmin satisfy a condition that DD1 ≤ 0.3 x DD2.

*FIG. 5*

**EP 3 550 591 A1**

**Description**

1. TECHNICAL FIELD

The present invention relates to a semiconductor wafer.

As a technology for growing a group-III nitride semiconductor crystal on a Si wafer, technologies as shown in the following documents, for example, have been considered.

Patent Document 1 has disclosed a group-III nitride epitaxial wafer that is made to suppress cracks occurring during a device forming process. The group-III nitride epitaxial wafer is characterized by including a Si wafer, an initial layer that is in contact with the Si wafer, and a super-lattice stack that is formed on the initial layer and that has a plurality of sets of stacks each having a first layer formed of AlGaN having an Al composition ratio that is larger than 0.5 and is 1 or less, and a second layer formed of AlGaN having an Al composition ratio that is larger than 0 and is 0.5 or less in this order, where the Al composition ratio of the second layer gradually decreases in a direction away from the wafer.

The Patent Document 2 has disclosed a compound semiconductor wafer that can suppress occurrence of cracks, crystal defect or warp of a nitride semiconductor layer, and can improve productivity. The compound semiconductor wafer includes a silicon single crystal wafer having a crystalline plane orientation denoted as the (111) plane, a first buffer layer formed on the silicon single crystal wafer and made of $Al_xGa_{1-x}N$ single crystal ($0 < x \leq 1$), a second buffer layer formed on the first buffer layer and including a plurality of first single layers and a plurality of second single layers that are alternately stacked, each first single layer being made of $Al_yGa_{1-y}N$ single crystal ($0 \leq y < 0.1$) having a thickness of 250 nm or more and 350 nm or less, and each second single layer being made of $Al_zGa_{1-z}N$ single crystal ($0.9 < z \leq 1$) having a thickness of 5.0 nm or more and 20 nm or less, and a semiconductor device forming region formed on the second buffer layer and including at least one or more of nitride-based semiconductor single crystal layers.

Patent Document 3 has disclosed a semiconductor electronic device that can further reduce leak current while suppressing a wafer from warping. The semiconductor electronic device is a semiconductor electronic device that includes a compound semiconductor layer stacked on a wafer with a buffer layer placed therebetween, where the buffer layer has a composite layer in which a second layer is stacked on a first layer, the second layer formed by using a nitride-based compound semiconductor having an Al composition of 0.8 or more, the first layer formed by using a nitride-based compound semiconductor having an Al composition of 0.2 or less.

The Non-Patent Document 1 has described that "it is prospective that if a film can be grown by alternately stacking GaN and AlN such that lattice relaxation is included in AlN on GaN and compressive stress is left in GaN on AlN, the entire film can have the compressive stress by using a strained periodic structure (generally called Strained Layer Super-lattice; hereinafter, referred to as SLS) of GaN/AlN. It is considered that in addition to the SLS, the compressive stress can also be added by using a combination in which an upper stacked film has a larger lattice constant."

[Prior Art Literature]

[Patent Document]

[Patent Document 1] Japanese Patent Application Publication No. 2013-021124

[Patent Document 2] Japanese Patent Application Publication No. 2010-232322

[Patent Document 3] Japanese Patent Application Publication No. 2008-171843

[Non-Patent Document]

[Non-Patent Document 1] K. Matsumoto et al., J. Vac. Soc. Jpn. 54, 6 (2011), p376-380

SUMMARY

When a group-III nitride semiconductor layer is formed on a Si wafer, the wafer may be warped, and the group-III nitride semiconductor layer may crack due to the difference in thermal expansion coefficient between Si and the group-III nitride semiconductor crystal. To address this issue, as described in the above-mentioned Patent and Non-Patent Documents, a layer in which internal compressive stress is generated (a stress generating layer) is formed in order to balance the generated compressive stress and the tensile stress generated in the nitride crystal layer due to the difference in thermal expansion coefficient. In this way, the semiconductor wafer is prevented from being warped when the room temperature is restored, and the group-III nitride semiconductor layer is prevented from cracking.

However, there are still many things unclear about the control of the warp of a semiconductor wafer by a stress generating layer. Accordingly, it is also important to observe, while making a structure or the physical property of the stress generating layer clear, a relation between the structure or the like and a result of warp experiment. From such a point of view, as a result of experiments and studies for the relation between the structure of the stress generating layer and the warpage, the present inventors achieved the present invention.

The purpose of the present invention is to clarify a relation, when a crystal layer such as a group-III nitride semiconductor is formed by using an epitaxial growth method, between the structure of the buffer layer in which stress is generated and a warpage of the semiconductor wafer, and to provide a semiconductor wafer having a small warpage by specifying the structure of the buffer layer in which the warpage falls within a proper range.

To solve the above-described issue, in a first aspect of the present invention, a semiconductor wafer is provided, the semiconductor wafer including a base wafer, a device forming layer and a buffer layer that is disposed between the base wafer and the device forming layer, the buffer layer having a stacked structure in which first crystal layers formed of $Al_xGa_{1-x}N$ and second crystal layers formed of $Al_yGa_{1-y}N$ are repeatedly stacked, where an average Al composition AVG (x) of the first crystal layers and an average Al composition AVG (y) of the second crystal layer satisfy the following conditions: $0 < AVG (x) \leq 1$, $0 \leq AVG (y) < 1$ and AVG (x) > AVG (y), and when TEM observation of a cross-section of the buffer layer is performed at an observation region including one of the first crystal layers, HAADF-STEM intensity I(D) which is a function of a depth D takes a local minimum value Imin at a depth Dmin and takes a local maximum value Imax at a depth Dmax (Dmax > Dmin), and a depth direction distance DD1 from a depth at which the I(D) takes an intermediate value Imid of the Imax and the Imin to a depth at which the I(D) takes the Imin in a monotonous decrease region disposed shallower than the Dmin, and a depth direction distance DD2 from a depth at which the I(D) takes the Imin to a depth at which the I(D) takes the Imax in a monotonous increase region disposed deeper than the Dmin satisfy the following condition: $DD1 \leq 0.3 \times DD2$. A second-order differentiation function of the $d^2I(D)/dD^2$ of the I(D) may also have zero-crossing points whose number is larger than 1 between the Dmin and the Dmax.

The term "average Al composition AVG $(\alpha)$" indicates an average value of Al composition ratios over a thickness direction of a crystal layer formed of $Al_\alpha Ga_{1-\alpha}N$, and is one of representative values of Al composition ratios in a case where the Al composition ratio changes in the thickness direction.

The term "observation region" indicates a visual field when a Transmission Electron Microscope (TEM) observation is performed on a first crystal layer that has one layer only, and the term "HAADF-STEM intensity I(D)" indicates gradations, that is, changes in electron beam intensity when observing a crystal layer by using a High-angle Annular Dark Field Scanning TEM (HAADF-STEM) method, as a function of a depth D (a distance in a depth direction from any position to the crystal layer. To reduce pulsation caused by an influence of an atom image, an electron beam intensity signal which is directly obtained from a HAADF-STEM image and on which a smoothing process is performed for an appropriate number of times may also be used as the "HAADF-STEM intensity I(D)". In a HAADF-STEM image, a heavy element looks bright and a light element looks dark, and a contrast in proportion to the square of the atom amount is obtained. For this reason, in a case of the $Al_xGa_{1-x}N$ crystal layer, a dark image in proportion to the value of the Al composition x (a low signal intensity) is observed.

The term "Dmin" is a depth indicating that the I(D) takes a local minimum in the observation region, and the term "Imin" indicates the local minimum value of the I(D). The term "Dmax" is a depth indicating that the I(D) takes a local maximum in the observation region, and the term "Imax" indicates the local maximum value of the I(D). The term "Imid" is an intermediate value between the Imin and the Imax, and Imid = (Imax-Imin)/2.

The term "second-order differentiation function $d^2I(D)/dD^2$" is a function obtained by further differentiating a first-order differentiation function dI(D)/dD of the I(D). The term "zero-crossing point" indicates a point of the depth D at which the second-order differentiation function $d^2I(D)/dD^2$ is 0 between a depth Dmin and a depth Dmax in the observation region.

The thermal expansion coefficient of the device forming layer may also be larger than the thermal expansion coefficient of the base wafer, and the average lattice constant of the second crystal layer may also be larger than the average lattice constant of the first crystal layer. The base wafer may also be a silicon wafer, and the device forming layer may also be a single layer or a stack formed of GaN or AlGaN. Between the base wafer and the buffer layer, a reaction suppressing layer that suppress a reaction between the silicon atom and the group-III atom may also be further included. Between the reaction suppressing layer and the buffer layer, an intermediate layer in which the lattice constant in the bulk crystal state is larger than the lattice constant of the reaction suppressing layer may also be further included. As an example of the reaction suppressing layer, an AlN layer formed at a low temperature can be given, and as an example of the intermediate layer, an AlGaN layer can be given.

It is preferable that the thickness of the first crystal layer is larger than 5.0 nm and less than 20 nm, the thickness of the second crystal layer is 10 nm or more and 300 nm or less, and the thickness of a nitride crystal layer that is disposed on the base wafer and includes the buffer layer and the device forming layer is 500 nm or more and 13000 nm or less. The AVG (x) and the AVG (y) may also satisfy the following conditions: $0.9 \leq AVG (x) \leq 1$ and $0 \leq AVG (y) \leq 0.3$.

BRIEF DESCRIPTION OF THE DRAWINGS

Fig. 1 shows a cross-sectional view of a semiconductor wafer 100.

Fig. 2 shows a HAADF-STEM image of observing a cross section of one example of the semiconductor wafer 100. (a) in Fig. 2 shows the entire region of a buffer layer 106 that is included in the visual field and that is observed, and (b) in Fig. 2 shows a part of the buffer layer 106 that is in the visual field (the observation region) in which a first crystal layer 106a is included by one layer only, and that is observed.

Fig. 3 shows, in (a), a cross-sectional TEM image in which one layer of the first crystal layer 106a and one layer of the second crystal layer 106b in one example of Fig. 2 are included in the visual field and are observed, and shows, in (b), an EDX analysis result of each position to which a figure is added on the cross-sectional TEM image.

Fig. 4 is a graph showing the HAADF-STEM intensity I(D) in the observation region as a function of the depth D, and shows data before smoothing and after smoothing together.

Fig. 5 is a graph showing, as a function of the depth D, the HAADF-STEM intensity I(D), the first-order differentiation function dI(D)/dD and the second-order differentiation function $d^2I(D)/dD^2$ in an observation region in an experimental example 1.

Fig. 6 is a graph showing , as a function of the depth D, the HAADF-STEM intensity I(D), the first-order differentiation function dI(D)/dD and the second-order differentiation function $d^2I(D)/dD^2$ in an observation region in an experimental example 2.

Fig. 7 is a graph showing , as a function of the depth D, the HAADF-STEM intensity I(D), the first-order differentiation function dI(D)/dD and the second-order differentiation function $d^2I(D)/dD^2$ in an observation region in an experimental example 3.

Fig. 8 is a graph showing , as a function of the depth D, the HAADF-STEM intensity I(D), the first-order differentiation function dI(D)/dD and the second-order differentiation function $d^2I(D)/dD^2$ in an observation region in a comparative example.

DESCRIPTION OF EXEMPLARY EMBODIMENTS

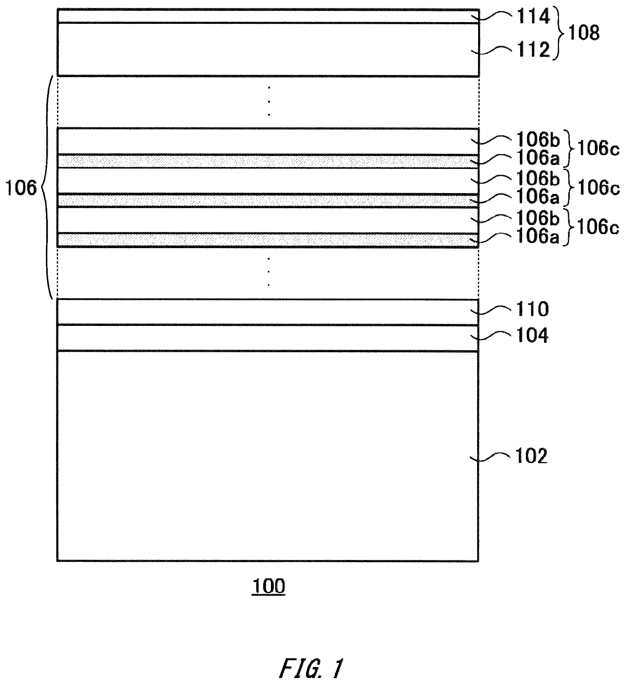

Fig. 1 is a cross-sectional view of the semiconductor wafer 100. The semiconductor wafer 100 includes a base wafer 102, a reaction suppressing layer 104, a buffer layer 106 and a device forming layer 108. An intermediate layer 110 is included between the reaction suppressing layer 104 and the buffer layer 106. Note that the reaction suppressing layer 104, the buffer layer 106 and the device forming layer 108 on the base wafer 102 are each, for example, a group-III nitride crystal layer, and in this case, can be formed by using a general MOCVD method.

The base wafer 102 is a support wafer that supports the reaction suppressing layer 104, the buffer layer 106 and the device forming layer 108. The base wafer 102 is preferably a silicon wafer. By using a silicon wafer as the base wafer 102, material costs can be reduced, and a semiconductor manufacturing apparatus that has been used in a conventional silicon process can be utilized. Accordingly, cost competitiveness can be enhanced. Further, by using a silicon wafer as the base wafer 102, a large wafer whose diameter is 150 mm or more can be industrially utilized at a low price.

When a silicon wafer is used as the base wafer 102, the device forming layer 108 can be made as a single layer or stack formed of GaN or AlGaN. In this case, the meaning of providing the reaction suppressing layer 104 is significant.

The reaction suppressing layer 104 is disposed between the base wafer 102 and the buffer layer 106. The reaction suppressing layer 104 suppresses a reaction between atoms forming the base wafer 102, for example, a silicon atom and a group-III atom. For example, when an upper layer of the reaction suppressing layer 104 is a Group-III nitride semiconductor layer, the reaction suppressing layer 104 can prevent alloying between Ga contained in the group-III nitride semiconductor layer, and atoms (for example, Si) contained in the base wafer 102. As an example of the reaction suppressing layer 104, $Al_{x1}Ga_{1-x1}N$ ($0 < x1 \leq 1$) can be given, and as a representative example, an AlN layer can be given. According to the reaction suppressing layer 104, a surface of the base wafer 102 can be protected, and accordingly, the upper layers can be surely supported. Also, the reaction suppressing layer 104 can form an initial nucleus of a crystal layer that is formed on the base wafer 102.

The buffer layer 106 is disposed between the base wafer 102 and the device forming layer 108. The buffer layer 106 includes a stacked structure 106c in which first crystal layers 106a and second crystal layers 106b are repeatedly stacked. The buffer layer 106 functions as a stress generating layer that reduces the warp of the entire semiconductor wafer 100.

The first crystal layer 106a is formed of $Al_xGa_{1-x}N$, and the second crystal layer 106b is formed of $Al_yGa_{1-y}N$. Then, the average Al composition AVG (x) of the first crystal layer 106a and the average Al composition AVG (y) of the second crystal layer 106b satisfy the following conditions: $0 < AVG (x) \leq 1$, $0 \leq AVG (y) < 1$, and AVG (x) > AVG (y). It is preferable that the AVG (x) and the AVG (y) satisfy the following conditions: $0.9 \leq AVG (x) \leq 1$ and $0 \leq AVG (y) \leq 0.3$. The thickness of the first crystal layer 106a can be made to be 1 nm or more and 20 nm or less, and preferably, can be made to be larger than 5.0 nm and less than 20 nm. The thickness of the second crystal layer 106b can be made to be 5 nm or more and 300 nm or less, and preferably, can be made to be 10 nm or more and 300 nm or less.

As an example of the first crystal layer 106a, an AlN layer can be given, and as an example of the second crystal layer 106b, an AlGaN layer can be given. An interface between the first crystal layer 106a and the second crystal layer 106b is not necessarily a clear interface and may also be an interface in which the Al composition ratio continuously changes in the depth direction.

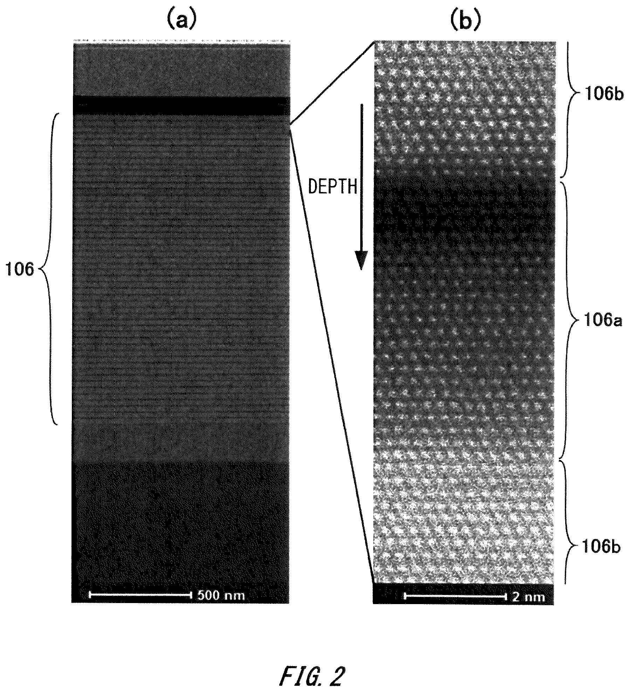

Fig. 2 shows a HAADF-STEM image of observing a cross section of one example of the semiconductor wafer 100. (a) in Fig. 2 shows the entire region of a buffer layer 106 that is included in the visual field and that is observed, and (b) in Fig. 2 shows a part of the buffer layer 106 that is in the visual field (the observation region) in which a first crystal layer 106a is included by one layer only, and that is observed. From (a) in Fig. 2, a stacked structure of the buffer layer 106 can be confirmed. Also, in (b) in Fig. 2, the observed HAADF-STEM image shows that the upper side (the side at a small depth) of the first crystal layer 106a is dark and the lower side (the side at a large depth) is bright. Considering the characteristic of the observed HAADF-STEM image showing that the heavier element looks brighter, it is concluded that the Al composition in the first crystal layer 106a is small on the lower side (the side at a large depth) and is large on the upper side (the side at a small depth),

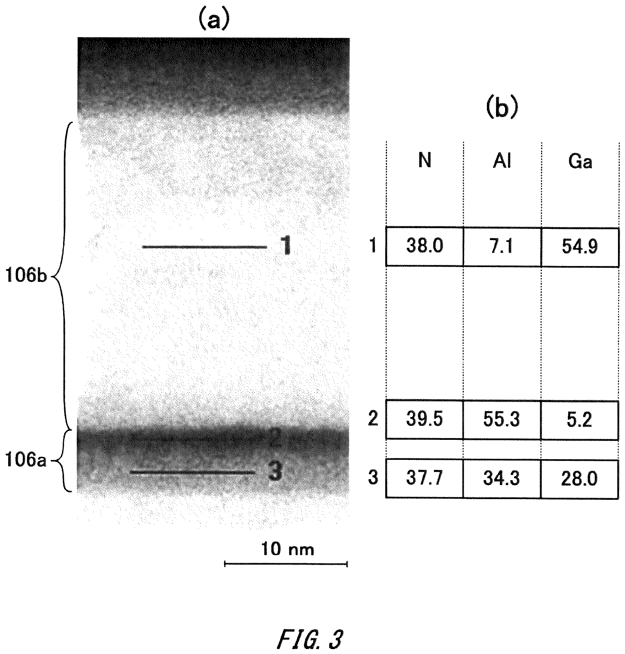

(a) in Fig. 3 shows a cross-sectional TEM image of observing the first crystal layer 106a and the second crystal layer 106b in one example of Fig. 2, in which one first crystal layer 106a and one second crystal layer 106b are respectively included in the visual field and are observed. (b) in Fig. 3 shows a result of an Energy dispersive X-ray spectrometry (EDX) analysis on each position to which a figure is added on the cross-sectional TEM image in (a) in Fig. 3, and the figure is an atom composition ratio (the unit is atom%) of N atoms, Al atoms, and Ga atoms to a total of the composition.

The Al composition ratio and the Ga composition ratio of the second crystal layer 106b to which the figure "1" is added are respectively 7.1% and 54.9%, the Al composition ratio and the Ga composition ratio in the upper portion of the first crystal layer 106a to which the figure "2" is added are respectively 55.3% and 5.2%, the Al composition ratio and the Ga composition ratio in the lower portion of the first crystal layer 106a to which the figure "3" is added are respectively 34.3% and 28.0%. Accordingly, it can be learned that the composition of the second crystal layer 106b is close to GaN, the composition of the upper portion of the first crystal layer 106a is close to AlN, and the composition of the lower portion of the first crystal layer 106a is approximately the middle of GaN and AlN. Because an introduction of Ga source material gas is not intentional during the process of forming the first crystal layer 106a, it can be said that a phenomenon that lots of Al atoms are substituted with Ga atoms in the lower portion of the first crystal layer 106a occurs. Note that although reasons of the occurrence of such a substituent phenomenon are unclear, a possibility of a mixture or the like of the residue of Ga atoms within a furnace while forming the first crystal layer 106a is considered as one of the reasons.

Taking these experiment considerations into account, the present inventors analyzed in detail the Al composition (Al/Ga composition ratio) in the depth direction of the first crystal layer 106a by quantifying the gradations of the HAADF-STEM image, found out a correlation between the Al composition and the warpage of the semiconductor wafer, and achieved the present invention.

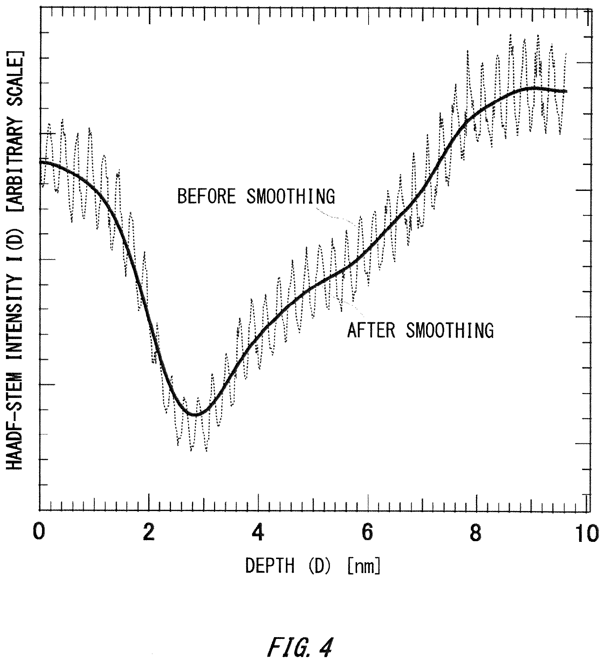

Fig. 4 is a graph showing the HAADF-STEM intensity I(D) in an observation region as a function of the depth D. In an HAADF-STEM image, to observe atoms, the HAADF-STEM intensity I(D) shows a pulsation that reflects the atoms (before smoothing). A smoothing process has been performed for an appropriate number of times on the data after smoothing in Fig. 4 to reduce the pulsation, and it is preferable to use the data after smoothing during a detailed examination of the Al composition.

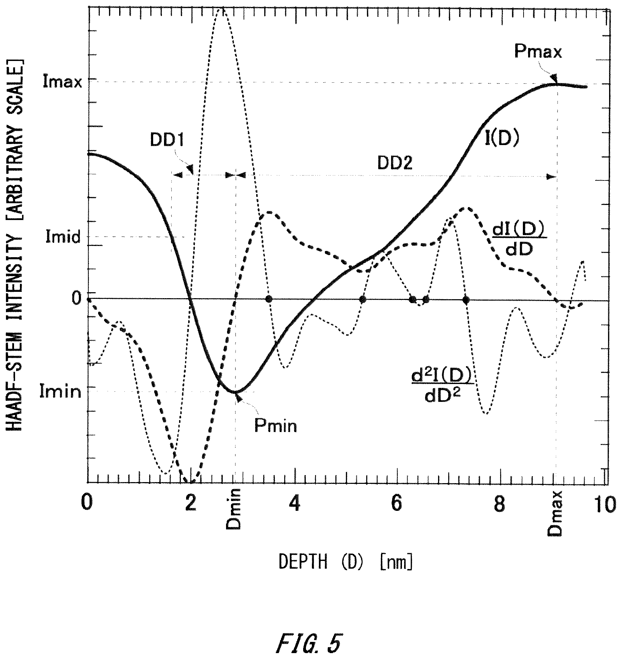

Fig. 5 is a graph showing one example of the HAADF-STEM intensity I(D) in the observation region and shows the first-order differentiation function $dI(D)/dD$ and the second-order differentiation function $d^2I(D)/dD^2$ of the I(D) together. The HAADF-STEM intensity I(D) takes a local minimum value Imin at a depth Dmin and takes a local maximum value Imax at a depth Dmax (Dmax > Dmin). In a monotonous decrease region that is positioned shallower that the Dmin, the I(D) decreases from an intermediate value Imid between the Imax to the Imin to the Imin, and a depth-direction distance from the Imid to the Imin is taken as DD1. In a monotonous increase region that is positioned deeper than the Dmin, the I(D) increases from the Imin to the Imax, and a depth direction distance from the Imin to the Imax is taken as DD2. When the depth direction distances DD1 and DD2 are defined in this way, it is characterized that the following condition is satisfied: DD1 $\leq$ 0.3 x DD2. By satisfying the condition, the warpage of the semiconductor wafer 100 can be made small. Note that it is desirable that the above-described condition to be satisfied is preferably that DD1 $\leq$ 0.25 x DD2, and more preferably, is that DD1 $\leq$ 0.2 x DD2.

Note that it is desirable that the second-order differentiation function $d^2I(D)/dD^2$ of the I(D) has zero-crossing points whose number is larger than 1 between the Dmin and the Dmax. The zero-crossing point is a point at which the $d^2I(D)/dD^2$ intersects the axis of the intensity 0, which is shown by the "black circles" in the drawing. By satisfying the condition, the warpage of the semiconductor wafer 100 can be made small.

The first crystal layer 106a has a large electric resistance because of the average Al composition AVG (x) thereof is large. Also, by repeatedly stacking the stacked structures 106c including the first crystal layer 106a and the second crystal layer 106b, a blocking voltage can be increased. For this reason, the characteristics such as the blocking voltage and mobility of the active layer 112 can be improved while reducing the warp of the semiconductor wafer 100.

The second crystal layer 106b is ideally formed such that the crystal lattices of the second crystal layer 106b are coherently continuous from the crystal lattices of the first crystal layer 106a at the hetero-junction plane between the second crystal layer 106b and the first crystal layer 106a. As described above, the lattice constant in a bulk state of the second crystal layer 106b is larger than the lattice constant in a bulk state of the first crystal layer 106a such that the average Al composition AVG (x) of the first crystal layer 106a and the average Al composition AVG (y) of the second crystal layer 106b satisfy the conditions that 0 < AVG (x) $\leq$ 1, 0 $\leq$ AVG (y) < 1 and AVG (x) > AVG (y). For this reason, compressive stress to the first crystal layer 106a is accumulated in the second crystal layer 106b. Accordingly, the compressive stress is generated in the buffer layer 106. According to the occurrence of the compressive stress in the buffer layer 106, the compressive stress and tensile stress generated in the nitride crystal layer due to a difference in the thermal expansion coefficient are balanced; therefore, the warp of the semiconductor wafer 100 can be reduced.

Also, the buffer layer 106 has a plurality of stacked structures 106c. The plurality of stacked structures 106c may also constitute a super-lattice structure in which a large number of the stacked structures 106c are repeatedly stacked. The number of repeatedly-stacked structures 106c can be made to be 2 to 500, for example. By stacking a large number of the stacked structures 106c, the compressive stress generated in the buffer layer 106 can be made large. Also, the magnitude of the compressive stress generated in the buffer layer 106 can be easily controlled by the number of the stacks of the stacked structures 106c. Further, by stacking a large number of the stacked structures 106c, the improvement of the blocking voltage by the first crystal layer 106a can be further enhanced.

The device forming layer 108 is a crystal layer in which any device such as a transistor or a light emitting diode (LED) can be formed, and for example, when a High Electron Mobility Transistor (HEMT) in which a two-dimensional electron gas (2DEG) is taken as a channel is to be formed, the device forming layer 108 can include an active layer 112 and a Schottky layer 114. As an example of the active layer 112, a GaN layer can be given, and as an example of the Schottky layer 114, an AlGaN layer can be given.

When the thermal expansion coefficient of the device forming layer 108 is larger than the thermal expansion coefficient of the base wafer 102, the average lattice constant of the second crystal layer 106b can be made to be larger than the average lattice constant of the first crystal layer 106a. That is, when the device forming layer 108 is formed by a MOCVD method and the like under a high-temperature environment, as the semiconductor wafer 100 is returned to a room temperature, because thermal contraction of the device forming layer 108 is larger than that of the base wafer 102, the device forming layer 108 receives tensile stress. In such a case, as described above, when the lattice constant in the bulk state of the second crystal layer 106b is set to be larger than the lattice constant in the bulk state of the first crystal layer 106a, the compressive stress is generated in the buffer layer 106 and the tensile stress by the device forming layer 108 can be cancelled.

The active layer 112 is, for example, formed of $Al_{x4}Ga_{1-x4}N$ (0 $\leq$ x4 < 1), and is typically a GaN layer. The active layer 112 may also be an AlInGaN layer. The active layer 112 is a layer in which an electron device is to be formed later. The active layer 112 can be divided into two layers, where the upper layer can be a high-purity layer formed of carbon atoms and the like having an impurity concentration that is as small as possible, and the lower layer can be a layer containing carbon atoms. The presence of the carbon atoms in the lower layer can contribute to increase the blocking voltage and the high purity of the upper layer can contribute to reduce the scattering of the carriers caused by the impurity atoms and thus increase the mobility.

The Schottky layer 114 is, for example, an $Al_{x5}Ga_{1-x5}N$ (0 < x5 < 1). Two-dimensional electron gas (2DEG) is generated at the hetero interface between the active layer 112 and the Schottky layer 114, which can function as a channel layer of the transistor.

The Schottky layer 114 can be appropriately modified in accordance with the structure of the transistor to be formed.

The thickness of the nitride crystal layer including the buffer layer 106 and the device forming layer 108 disposed on the base wafer 102 can be made to be 6 nm or more and 20000 nm or less, and preferably, can be 500 nm or more and 13000 nm or less. Since the nitride crystal layer is configured to have a thickness within this range, the warpage of the semiconductor wafer 100 can be reduced. When the thickness of the base wafer 102 is 400 $\mu$m or more and the diameter of the base wafer 102 is 100 mm or more, the thickness of the reaction suppressing layer 104 is preferably 30 nm or more and 300 nm or less. By making the base wafer 102 and the reaction suppressing layer 104 within the range, the warpage of the semiconductor wafer 100 can be reduced.

The above-described nitride crystal layer has a larger thermal expansion coefficient than the base wafer 102, and as the temperature is decreased from a high temperature at the time of epitaxial growth to the room temperature, the nitride crystal layer is contracted more largely than the base wafer 102, and as a result, the tensile stress is generated in the nitride crystal layer. However, according to the semiconductor wafer 100 of the present embodiment, because the compressive stress by the buffer layer 106 is generated, the compressive stress and the tensile stress by the decrease of the temperature in the nitride crystal layer are balanced, and the warp of the semiconductor wafer 100 can be suppressed.

Note that as long as the stacked structure 106c made of the first crystal layer 106a and the second crystal layer 106b is included in the buffer layer 106, the other layers of the buffer layer 106 can be in an arbitrary configuration. Although an example in which the intermediate layer 110 is formed between the reaction suppressing layer 104 and the buffer layer 106 is described in the above, the intermediate layer 110 may also be formed between the buffer layer 106 and the device forming layer 108, and on an upper layer of the device forming layer 108.

The intermediate layer 110 is a layer which is disposed between the reaction suppressing layer 104 and the buffer layer 106 and is in contact with the reaction suppressing layer 104, and in which the lattice constant in the bulk crystal state is larger than the lattice constant of the reaction suppressing layer 104. The intermediate layer 110 is, for example, formed of $Al_{x2}Ga_{1-x2}N$ ($0 < x2 < 1$). The intermediate layer 110 can be ideally formed such that the crystal lattices of the intermediate layer 110 are coherently continuous from the crystal lattices of the reaction suppressing layer 104 at the hetero-junction plane between the intermediate layer 110 and the reaction suppressing layer 104. Accordingly, in the intermediate layer 110, the compressive stress is generated due to a difference in the lattice constant from the reaction suppressing layer 104. Also, in the intermediate layer 110, the initial nucleus formed in the reaction suppressing layer 104 is expanded, and a base surface of the buffer layer 106 formed on the upper layer is formed. The thickness of the intermediate layer 110 can be made to be 600 nm or less, for example, 300 nm.

Note that the above describes that the intermediate layer 110 and the reaction suppressing layer 104 are coherently continuous at the hetero interface therebetween, but this requirement is merely ideal. In reality, lattice relaxation occurs due to defects and the like and the coherently grown regions are merely dominant. This has been similarly explained in relation to the hetero interface between the first crystal layer 106a and the second crystal layer 106b.

[Embodiments]

A plurality of semiconductor wafers 100 (experimental examples 1 to 3 and a comparative example).having different HAADF-STEM intensities I(D) in an observation region were manufactured. That is, as the semiconductor wafers 100 of the experimental examples 1 to 3 and the comparative example, a Si wafer was used for the base wafer 102, and an AlN layer having a designed thickness of 150 to 160 nm and an AlGaN layer having a designed thickness of 250 nm were formed on the (111) plane of the Si wafer as the reaction suppressing layer 104 and the intermediate layer 110. Further, AlN/AlGaN stacked structures (the stacked structures 106c) each made of an AlN layer (the first crystal layer 106a) having a designed thickness of 5 nm and an AlGaN layer (the second crystal layer 106b) having a designed thickness of 28 nm were repeatedly stacked and formed as the buffer layer 106, and a GaN layer (the active layer 112) having a designed thickness of 800 nm and an AlGaN layer (the Schottky layer 114) having a designed thickness of 20 to 50 nm were formed as the device forming layer 108.

A Metal Organic Chemical Vapor Deposition (MOCVD) method was used for forming each of the above-described AlN layer, AlGaN layer and GaN layer. In the MOCVD method, trimethylaluminum ($Al(CH_3)_3$) and trimethyl-gallium ($Ga(CH_3)_3$) were used as group-III source material gas, and ammonia ($NH_3$) was used as nitrogen source material gas. The growth temperature is selected within a range from 1100 °C to 1260 °C, and a V/III ratio, that is, a flow rate ratio of the group-V source material gas to the group-III source material gas is selected within a range from 160 to 3700. Note that growth time corresponding to the designed thickness is calculated from a growth rate obtained by a preliminary experiment, and the thickness of each layer is controlled by the growth time, and accordingly, the actual thickness and the designed thickness of each layer are different from each other.

To make the depth profile I(D) of the HAADF-STEM intensity in the observation region in the experimental examples 1 to 3 and the comparative example different, the growth condition of the buffer layer 106 (a stack obtained by repeatedly stacking the AlN layers (the first crystal layers 106a) and the AlGaN layers (the second crystal layers 106b) was changed respectively in the experimental examples 1 to 3 and the comparative example.

In the experimental example 1, growth interruption at the time of growth switching between the AlN layer and the AlGaN layer (referred to as "growth interruption" in some cases) was set to "YES", the V/III ratio of the AlN layer (the first crystal layer 106a) was set to be 1580 and the Al composition of AlGaN layer (the second crystal layer 106b) was set to 0.18. In the experimental example 2, the growth interruption was set to "NO" and the others were set the same as the experimental example 1. In the experimental example 3, the Al composition of the AlGaN layer was set to 0.33, and the others were set the same as the experimental example 1. In the comparative example, the V/III ratio of the AlN layer was set to 260, and the others were set the same as the experimental example 1. Note that the "Al composition" here is a "target value" in the growth condition and is different from the Al composition in an actual crystal layer.

For each semiconductor wafer manufactured in the experimental examples 1 to 3 and the comparative example, the HAADF-STEM intensity $I(D)$ was measured, the first-order differentiation function $dI(D)/dD$ and the second-order differentiation function $d^2I(D)/dD^2$ were calculated, and the DD1, the DD2 and the number of zero-crossing points were evaluated. Also, for each semiconductor wafer, the warpage was measured.

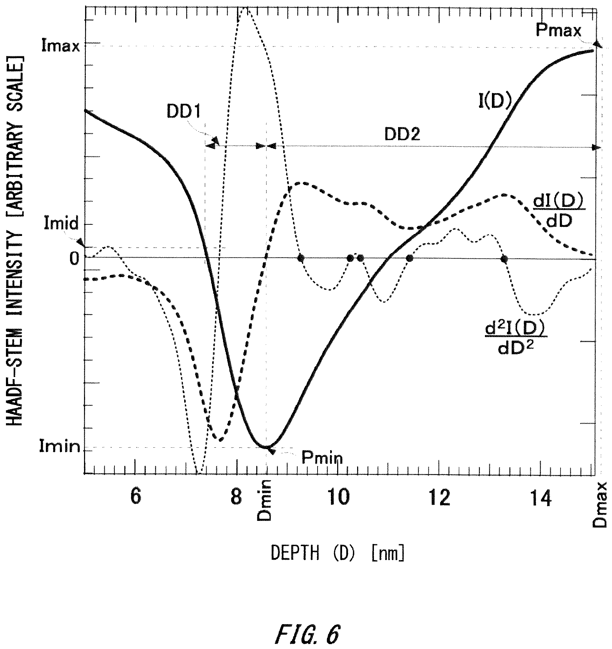

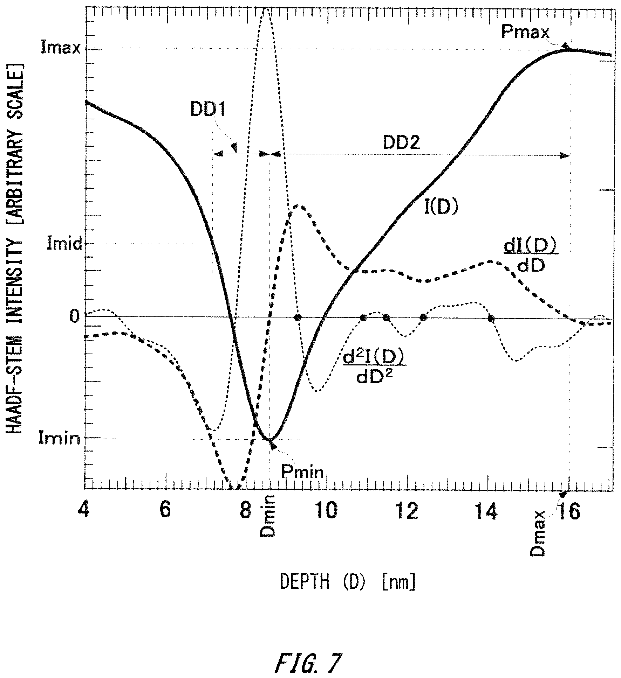

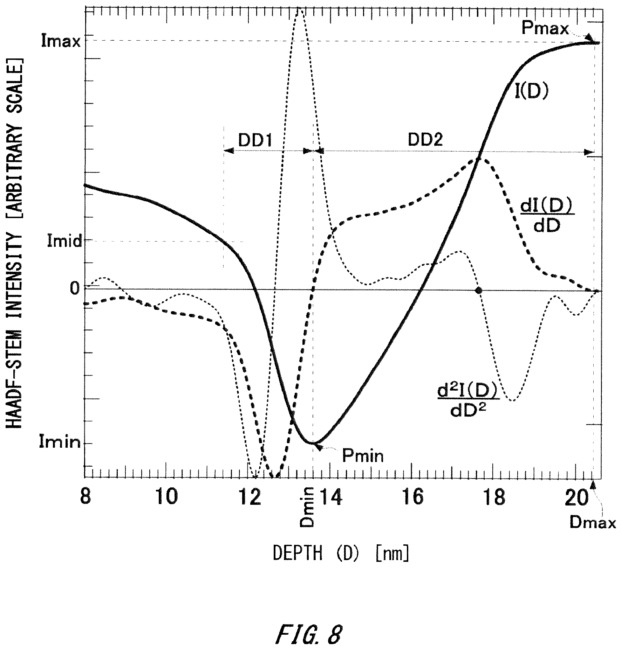

Fig. 5 to Fig. 8 are graphs each showing the HAADF-STEM intensity $I(D)$ in the observation region, the first-order differentiation function $dI(D)/dD$ and the second-order differentiation function $d^2I(D)/dD^2$ as a function of the depth D. Fig. 5 shows the experimental example 1, Fig. 6 shows the experimental example 2, Fig. 7 shows the experimental example 3 and the Fig. 8 shows the comparative example. Table 1 shows characteristic forming condition in the experimental examples 1 to 3 and the comparative example, a ratio of DD1 to DD2 (DD1/DD2), the number of the zero-crossing points, and the warpage in summary.

[TABLE 1]

| | FIRST CRYSTAL LAYER (AlN) | | SECOND CRYSTAL LAYER (AlGaN) | | | DD1/DD2 | NUMBER OF ZERO-CROSSING POINTS | WARPAGE ($\mu$m) |
|---|---|---|---|---|---|---|---|---|
| | GROWTH INTERRUPTION | V/III RATIO | AICOMPOSITION (y) | GROWTH INTERRUPTION | V/III RATIO | | | |
| EMBODIMENT 1 | YES | 1580 | 0.18 | YES | 160 | 19.54 | 5 | 32 |
| EMBODIMENT 2 | NO | 1580 | 0.18 | NO | 160 | 18.34 | 5 | 90 |
| EMBODIMENT 3 | YES | 1580 | 0.33 | YES | 211 | 19.22 | 5 | -33 |
| COMPAR A-TIVE EXAMPLE | YES | 260 | 0.18 | YES | 201 | 31.28 | 1 | 173 |

As shown in Fig. 5 to Fig. 8, it can be learned that in the experimental examples 1 to 3 and the comparative example, the profiles I(D) in the depth direction of the HAADF-STEM intensity are different from each other, and the Al compositions (a situation of the change in the composition ratio of Ga atoms from the AlGaN layer to the AlN layer) in the buffer layer 106 (a stack obtained by repeatedly stacking the AlN layer (the first crystal layer 106a) and the AlGaN layer (the second crystal layer 106b)) in the respective samples are different from each other.

Corresponding to the difference in the I(D) between the experimental examples 1 to 3 and the comparative example, the DD1 and the DD2 are different in the experimental examples 1 to 3 and the comparative example. In the experimental examples 1 to 3 in which an absolute value of the warpage falls within 90 $\mu$m, DD1/DD2 is 0.2 or less. On the other hand, in the comparative example in which the warpage is as large as 173 $\mu$m, DD1/DD2 is as large as 0.3 or more. Also, in the experimental examples 1 to 3 in which the warpage is small, the number of the zero-crossing points is 5. On the other hand, in the comparative example in which the warpage is large, the number of the zero-crossing points is 1.

From the above embodiments, it can be said that it is possible to evaluate the warpage of the wafer by DD1/DD 2 or the number of zero-crossing points, and a good warpage can be obtained if DD1/DD2 and the number of zero-crossing points are respectively 0.3 or less (preferably, 0.2 or less) and larger than 1 (preferably, 5 or more).

As described above, by making the DD1 and DD2 defined by the HAADF-STEM intensity I(D) in the observation region of the buffer layer 106 so as to satisfy the condition that DD1 $\leq$ 0.3 x DD2 (preferably, DD1 $\leq$ 0.25 x DD2, and more preferably, DD1 $\leq$ 0.2 x DD2), the warpage of the semiconductor wafer can be made small. Also, by making the number of zero-crossing points defined by the second-order differentiation function $d^2I(D)/dD^2$ of the I(D) to be larger than 1 (preferably, 5 or more), the warpage of the semiconductor wafer can be made small.

EXPLANATION OF REFERENCES

100 ... semiconductor wafer; 102 ... base wafer; 104 ... reaction suppressing layer; 106 ... buffer layer; 106a ... first crystal layer; 106b ... second crystal layer; 106c ... stacked structure; 108 ... device forming layer; 110 ... intermediate layer; 112 ... active layer; 114 ... Schottky layer

**Claims**

1. A semiconductor wafer comprising a base wafer, a device forming layer, and a buffer layer that is disposed between the base wafer and the device forming layer, the buffer layer having a stacked structure in which first crystal layers formed of $Al_xGa_{1-x}N$ and second crystal layers formed of $Al_yGa_{1-y}N$ are repeatedly stacked, wherein an average Al composition AVG (x) of the first crystal layer and an average Al composition AVG (y) of the second crystal layer satisfy the following conditions:

$$0 < AVG\ (x) \leq 1;$$

$$0 \leq AVG\ (y) < 1;$$

and

$$AVG\ (x) > AVG\ (y),$$

wherein

when TEM observation of a cross-section of the buffer layer is performed at an observation region including one of the first crystal layers, HAADF-STEM intensity I(D) which is a function of a depth D takes a local minimum value Imin at a depth Dmin and takes a local maximum value Imax at a depth Dmax (Dmax > Dmin), and a depth direction distance DD1 from a depth at which the I(D) takes an intermediate value Imid of the Imax and the Imin to a depth at which the I(D) takes the Imin in a monotonous decrease region disposed shallower than the Dmin, and a depth direction distance DD2 from a depth at which the I(D) takes the Imin to a depth at which the I(D) takes the Imax in a monotonous increase region disposed deeper than the Dmin satisfy the following condition: DD1 $\leq$ 0.3 x DD2.

**2.** The semiconductor wafer according to Claim 1, wherein
a second-order differentiation function $d^2I(D)/dD^2$ of the I(D) has zero-crossing points whose number is larger than 1 between the Dmin and the Dmax.

**3.** The semiconductor wafer according to Claim 1 or 2, wherein
a thermal expansion coefficient of the device forming layer is larger than a thermal expansion coefficient of the base wafer, and
an average lattice constant of the second crystal layer is larger than an average lattice constant of the first crystal layer.

**4.** The semiconductor wafer according to Claim 3, wherein
the base wafer is a silicon wafer, and
the device forming layer is a single layer or a stack formed of GaN or AlGaN.

**5.** The semiconductor wafer according to any one of Claims 1 to 4, further comprising, between the base wafer and the buffer layer, a reaction suppressing layer that suppresses a reaction between silicon atoms and group-III atoms.

**6.** The semiconductor wafer according to Claim 5, further comprising, between the reaction suppressing layer and the buffer layer, an intermediate layer having a lattice constant in a bulk crystal state larger than a lattice constant of the reaction suppressing layer.

**7.** The semiconductor wafer according to any one of Claims 1 to 6, wherein
a thickness of the first crystal layer is larger than 5.0 nm and is less than 20 nm,
a thickness of the second crystal layer is 10 nm or more and 300 nm or less, and
a thickness of a nitride crystal layer that is disposed on the base wafer and that includes the buffer layer and the device forming layer is 500 nm or more and 13000 nm or less.

**8.** The semiconductor wafer according to any one of Claims 1 to 7, wherein
the AVG (x) and the AVG (y) satisfy the following conditions:

$$0.9 \leq AVG\,(x) \leq 1;$$

and

$$0 \leq AVG\,(y) \leq 0.3.$$

FIG. 1

FIG. 2

(a)

(b)

| | N | Al | Ga |
|---|---|---|---|
| 1 | 38.0 | 7.1 | 54.9 |
| 2 | 39.5 | 55.3 | 5.2 |
| 3 | 37.7 | 34.3 | 28.0 |

FIG. 3

FIG. 4

*FIG. 5*

*FIG. 6*

*FIG. 7*

*FIG. 8*

<div align="center">

**INTERNATIONAL SEARCH REPORT**

</div>

| | International application No. |
|---|---|
| | PCT/JP2017/042694 |

**A. CLASSIFICATION OF SUBJECT MATTER**

Int. Cl. H01L21/205(2006.01)i, C23C16/30(2006,01)i, C23C16/34(2006.01)i, H01L21/338(2006.01)i, H01L29/778(2006.01)i, H01L29/812(2006.01)i

According to International Patent Classification (IPC) or to both national classification and IPC

**B. FIELDS SEARCHED**

Minimum documentation searched (classification system followed by classification symbols)
Int. Cl. H01L21/205, C23C16/30, C23C16/34, H01L21/338, H01L29/778, H01L29/812

Documentation searched other than minimum documentation to the extent that such documents are included in the fields searched
Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | WO 2016/072521 A1 (SUMITOMO CHEMICAL CO., LTD.) 12 May 2016, paragraphs [0035], [0042]-[0043], [0077]-[0080], [0093]-[0094], tables 1, 2, fig. 18 & US 2017/0236906 A1, paragraphs [0045], [0052]-[0053], [0088]-[0092], [0105]-[0106], tables 1, 2, fig. 18 & DE 112015005069 T5 & KR 10-2017-0077227 A & CN 107078034 A & AT 518350 A & TW 2 1624695 A | 1<br>3-8<br>2 |
| Y<br>A | 松本功, 他, シリコン基板上 GaN パワーデバイスエピタキシャル成長用有機金属気相成長装置の現状と課題 Journal of the Vaccum Society of Japan, 15 December 2011, vol. 54, no.6, pp. 376-380, in particular, table 1 (MATSUMOTO, Koh et al. Present Status and Challenge of Metal Organic Vapor Phase Epitaxy Equipment for the Epitaxial Growth of GaN Power Electronic Devices on Silicon Substrate. Journal of the Vacuum Society of Japan) | 3-8<br>1-2 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| | |

| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2017/042694

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2014-103400 A (NIPPON GLASS CO., LTD.) 05 June 2014, & US 2012/0126293 A1 & WO 2011/016304 A1 & DE 112010003214 B & CN 102484049 A | 1-8 |

Form PCT/ISA/210 (continuation of second sheet) (January 2015)

**EP 3 550 591 A1**

**REFERENCES CITED IN THE DESCRIPTION**

**Patent documents cited in the description**

- JP 2013021124 A
- JP 2010232322 A
- JP 2008171843 A

**Non-patent literature cited in the description**

- **K. MATSUMOTO et al.** *J. Vac. Soc. Jpn.,* 2011, vol. 54 (6), 376-380